# EUROPÄISCHE PATENTSCHRIFT

(11) **EP 2 219 213 B1**
(45) Veröffentlichungstag und Bekanntmachung des Hinweises auf die Patenterteilung: **25.07.2012**
(21) Anmeldenummer: 09016022.7
(22) Anmeldetag: 24.12.2009
(51) Int. Cl.: H01L 21/56, H01L 23/31

(54) **Halbleiteranordnung**
Semiconductor assembly
Assemblage à semi-conducteurs

(30) Priorität: 16.02.2009 DE 102009000888
(43) Veröffentlichungstag der Anmeldung: 18.08.2010
(73) Patentinhaber: SEMIKRON Elektronik GmbH & Co. KG, 90431 Nürnberg (DE)
(72) Erfinder: Braml, Heiko, Dr., 91346 Wiesenttal (DE); Fey, Tobias, Dr., 91058 Erlangen (DE); Göbl, Christian, 90441 Nürnberg (DE); Sagebaum, Ulrich, 90408 Nürnberg (DE)

(56) Entgegenhaltungen:
- EP-A1- 0 586 149
- EP-A1- 1 956 647
- EP-A2- 0 812 013
- WO-A2-2004/068550
- US-A1- 2007 222 060

## Beschreibung

Die Erfindung betrifft eine Halbleiteranordnung, insbesondere eine Leistungshalbleiteranordnung, nach dem Oberbegriff des Anspruchs 1.

Eine solche Halbleiteranordnung ist aus der US 6,624,216 bekannt. Bei der bekannten Halbleiteranordnung ist eine Unterfüllung zwischen einer mit Kontakten versehenen Oberseite eines Halbleiters und einer aus einem Folienverbund gebildeten elektrischen Verbindungseinrichtung aus einem Epoxidharz gebildet. Insbesondere bei Leistungshalbleiteranordnungen treten im Betrieb relativ hohe Temperaturen auf.

Die bekannten zur Unterfüllung verwendeten Epoxidharze müssen im gefrorenen Zustand meist bei einer Temperatur von -40°C gelagert werden. Das Material kann in der Praxis höchstens dreimal aufgetaut werden. Andernfalls ändern sich die Eigenschaften des Epoxidharzes, insbesondere dessen ohnehin geringe Topfzeit. Zur Verarbeitung ist es nachteiligerweise zunächst erforderlich, das Epoxidharz aufzutauen. Das ist zeitaufwändig. Ein weiterer Nachteil der bisher als Unterfüllmaterialien verwendeten Epoxidharze besteht darin, dass diese lediglich eine Temperaturbeständigkeit im Dauerbetrieb von maximal 170°C aufweisen. Zudem besitzt das bekannte Material eine Glasbildungstemperatur T_{G} unterhalb von 200°C. Oberhalb der Glasbildungstemperatur T_{G} ändert sich deren linearer Ausdehnungskoeffizient (CTE) sprunghaft. Das kann bei der Herstellung der Unterfüllung nachgelagerten Verfahrensschritten, beispielsweise beim Reflowlöten, zu unerwünschten Schäden oder Fehlern führen. Schließlich ist die Wärmeleitfähigkeit des bekannten Materials nicht besonders hoch. Sie beträgt in der Regel 0,25 bis 0,5 W/mK. Infolge dessen eignet es sich nicht oder nur bedingt zur Herstellung einer im Betrieb eine relativ große Wärmemenge freisetzenden Leistungshalbleiteranordnung.

Aus der EP 1 956 647 A1 und der US 2007/222060 A1 ist weiterhin eine Halbleiteranordnung bekannt, bei der ein Halbleiter mit einer aus einem Folienverbund gebildeten elektrischen Verbindungseinrichtung verbunden ist, wobei zwischen der Verbindungseinrichtung und der Oberseite des Halbleiters eine Unterfüllung aus einem Silikonkautschuk vorgesehen ist.

Aus der EP 0 586 149 A1 ist es weiterhin bekannt einen integrierten Schaltkreis, ein IC, mittels einer keramischen Beschichtung gegen Umwelteinflüsse zu schützen.

Aus der EP 0 812 013 A2 ist eine Methode zur Schutzversiegelung elektronsicher Bauteile bekannt. Dabei wird eine Keramiklage auf dem Bauteil angeordnet, auf dem weiter Lagen angeordnet werden. Zwischen verschiedene Lagen wird mit ein Füller eingebracht.

Aus der WO 2004/068550 A2 ist eine Verbindungsstruktur beinhaltend ein Metall, eine dielektrischen Verbindungslage und eine keramische Diffusionsbarriere, die als Diffusionssperre für das Metall, beispielsweise Kupfer dient.
Aufgabe der Erfindung ist es, die Nachteile nach dem Stand der Technik zu beseitigen. Es soll insbesondere eine Halbleiteranordnung angegeben werden, deren Verbund mit einer elektrischen Verbindungseinrichtung eine verbesserte Haltbarkeit aufweist.

Diese Aufgabe wird durch die Merkmale des Anspruchs 1 gelöst. Zweckmäßige Ausgestaltungen der Erfindung ergeben sich aus den Merkmalen der Ansprüche 2 bis 8.

Nach Maßgabe der Erfindung ist vorgesehen, dass die Unterfüllung eine aus einem präkeramischen Polymer gebildete Matrix aufweist. - Die vorgeschlagene Unterfüllung ist elektrisch isolierend; sie weist eine hervorragende Temperaturbeständigkeit auf. Sie kann hinsichtlich ihres linearen Ausdehnungskoeffizienten (CTE) so eingestellt werden, dass eine hervorragende Haltbarkeit einer Verbindung zwischen dem Halbleiter und der elektrischen Verbindungseinrichtung erreicht wird. Ferner kann das vorgeschlagene präkeramische Polymer bei Raumtemperatur gelagert werden. Seine Tropfzeit bei Raumtemperatur beträgt dabei mehrere Monate.

Im Sinne der vorliegender Erfindung werden unter dem Begriff "Kontakte" insbesondere an der Oberseite vorgesehene Kontaktflächen verstanden, welche durch ein Isolationsmittel voneinander getrennt sind. Derartige Kontaktflächen können eben, konvex oder konkav ausgestaltet sein. Unter dem Begriff "Folienverbund" wird ein flexibles Laminat aus zumindest einer metallischen Folienschicht und zumindest einer elektrisch isolierenden Folienschicht verstanden. Die zumindest eine elektrisch isolierende Folienschicht kann Durchbrüche aufweisen, so dass die metallische Folienschicht durch die Durchbrüche hindurch kontaktierbar ist. Es wird insoweit beispielsweise auf die DE 103 55 925 A1 verwiesen, welche beispielhaft einen Folienverbund beschreibt. Der Offenbarungsgehalt dieses Dokuments wird im Bezug auf die Beschreibung des Folienverbunds hiermit einbezogen.

Unter dem Begriff "präkeramisches Polymer" wird ein Polymer verstanden, welches mit zunehmender Temperatur zunächst in einen gelartigen und nachfolgend in einen duroplastischen Zustand übergeht. Im duroplastischen Zustand weist ein präkeramisches Polymer im Dauereinsatz in der Regel eine Temperaturbeständigkeit von bis zu 300°C auf. Bei einer weiteren Temperaturerhöhung können aus präkeramischen Polymeren keramische Werkstoffe hergestellt werden. Zu präkeramischen Polymeren gehören beispielsweise Polysilane, Polycarbosilane und Polyorganosilazane.

Nach einer vorteilhaften Ausgestaltung ist das präkeramische Polymer mit einem Füllgrad von bis zu 80 Vol.%, vorzugsweise bis zu 50 Vol.%, mit einem Füllstoff gefüllt. Damit lassen sich insbesondere die Fließeigenschaften des präkeramischen Polymers einstellen.

Zweckmäßigerweise handelt es sich bei dem Füllstoff um ein aus einem keramischen Material gebildetes Pulver mit einer mittleren Korngröße im Bereich von 0,5 bis 500 µm. Die vorgeschlagenen keramischen Materialien sind weitgehend inert. Deren Zusatz führt nicht zu unerwünschten chemischen Nebenreaktionen. Die vorgeschlagene mittlere Korngröße ermöglicht eine Applikation der präkeramischen Polymere mit herkömmlichen Applikationsmitteln, beispielsweise Nadeldispensern, Jet oder dgl.

Die Wärmeleitfähigkeit λ des keramischen Materials ist zweckmäßigerweise bei Raumtemperatur größer als 10 W/mK, vorzugsweise größer als 20 W/mK. Je nach Füllgrad gelingt es damit, die Wärmeleitfähigkeit des mit dem keramischen Material gefüllten präkeramischen Polymers auf Werte oberhalb von 2 W/mK zu steigern. Damit eignet sich das vorgeschlagene Material insbesondere zur Herstellung einer im Betrieb eine relativ große Wärmemenge freisetzenden Leistungshalbleiteranordnung.

Das keramische Material ist zweckmäßigerweise aus der folgende Gruppe ausgewählt: BN, SiC, Si₃N₄, AlN, Steatit, Codierit. Die vorgeschlagenen keramischen Materialien zeichnen sich durch eine hohe Wärmeleitfähigkeit aus.

Das präkeramische Polymer liegt zweckmäßigerweise in gelartiger oder duroplastischer Form vor. Die jeweils gewünschte Form wird durch den Vernetzungsgrad des präkeramischen Polymers bestimmt. Der Vernetzungsgrad wiederum kann beispielsweise durch Zufuhr von thermischer Energie eingestellt werden. Damit kann die Härte und die Steifigkeit des präkeramischen Polymers den jeweiligen Anforderungen angepasst werden. Das präkeramische Polymer weist in beiden Formen eine hohe Haftkraft auf Metallen, insbesondere auf Aluminium oder Kupfer auf, was zu einem besonders festen Verbund zwischen der elektrischen Verbindungseinrichtung und dem Halbleiter führt.

Es hat sich als zweckmäßig erwiesen, das präkeramische Polymer aus der folgenden Gruppe auszuwählen: Polysiloxan, Polysilazan, Polycarbosilan. Mit den vorgenannten Materialien lässt sich insbesondere die Tropfzeit erhöhen sowie die Lagerfähigkeit vereinfachen. Es kann eine Tropfzeit von 6 bis 9 Monaten bei einer Lagerung bei Raumtemperatur erreicht werden. Die Viskosität kann durch die Art des Füllstoffs, dessen mittlere Korngröße sowie den Füllgrad an die jeweiligen Anforderungen angepasst werden.

Nach einer weiteren Ausgestaltung ist vorgesehen, dass eine der Oberseite abgewandte Unterseite des Halbleiters mit einem Substrat verbunden ist. Der Halbleiter, insbesondere ein Leistungshalbleiter, kann auf dem Substrat aufgeklebt oder auch mit Montagemitteln, beispielsweise Schrauben, befestigt sein.

Nachfolgend wird ein Ausführungsbeispiel der Erfindung anhand der Zeichnungen näher erläuter. Es zeigen:
- Fig. 1: eine schematische Schnittansicht durch eine Halb- leiteranordnung und
- Fig. 2: eine Detailansicht des in Fig. 1 mit "A" bezeichne- ten Ausschnitts.

Bei der in den Figuren gezeigten Halbleiteranordnung sind auf einem Substrat 1 ein erster Leistungshalbleiter 2 unter Zwischenschaltung einer ersten Wärmeableitplatte 3 sowie ein zweiter Leistungshalbleiter 4 unter Zwischenschaltung einer zweiten Wärmeableitplatte 5 befestigt. Beim ersten Leistungshalbleiter 2 kann es sich beispielsweise um eine Leistungsdiode, beim zweiten Leistungshalbleiter 4 um einen Leistungstransistor handeln.

Mit dem Bezugszeichen 6 ist allgemein eine elektrische Verbindungseinrichtung bezeichnet, welche aus einem Folienverbund gebildet ist. Der Folienverbund umfasst eine erste Metallfolie 7, welche unter Vermittlung einer elektrisch isolierenden Folie 8 mit einer zweiten Metallfolie 9 laminiert ist. Die erste Metallfolie 7 ist mit an einer Oberseite des ersten 2 sowie des zweiten Halbleiterelements 4 bezeichneten Kontakten 10 elektrisch leitend verbunden. Bei den Kontakten 10 kann es sich um Kontaktflächen handeln.

Das Bezugszeichen 11 bezeichnet einen dritten Halbleiter, hier einen Treiberbaustein, welcher mittels eines hier in Form eines dünnen Drahts ausgebildeten Kontakts 10 mit der zweiten Metallfolie 9 elektrisch leitend verbunden ist.

Ein vierter Leistungshalbleiter 12 weist einen Kontakt 10 auf, welcher aus einer Bonding-Verbindung zwischen der zweiten Metallfolie 9 und einem Kontaktfeld 13 besteht, welches auf einer weiteren Oberseite des vierten Leistungshalbleiters 12 vorgesehen ist.

Selbstverständlich können an die Stelle von Leistungshalbleitern auch andere Halbleiter mit oder ohne Wärmeableitplatte oder andere Bauelemente treten.

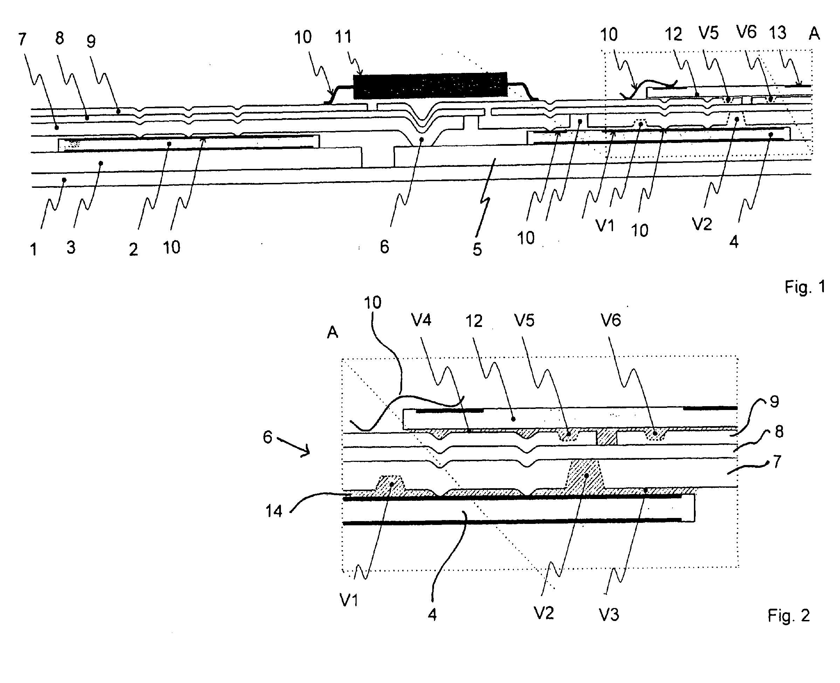

Wie insbesondere aus Fig. 2 ersichtlich ist, sind Volumina V1, V2, V3, V4, V5 und V6 zwischen einer der Verbindungseinrichtung 6 zugewandten Oberseite der Leistungshalbleiter 2, 4, 11, 12 mit einer Unterfüllung 14 ausgefüllt. Die Unterfüllung 14 ist hier aus einem präkeramischen Polymer gebildet, vorzugsweise einem Polysiloxan, welches mit einem Füllgrad von 20 bis 35 % mit einem SiC-Pulver mit einer mittleren Korngröße im Bereich von 1 bis 5 µm gefüllt ist. Die Unterfüllung 14 liegt hier in einem duroplastischen Zustand vor. Das hat den Vorteil, dass selbst bei Betriebstemperaturen im Bereich von bis zu 300°C die vorgeschlagene Unterfüllung ihre Eigenschaften kaum ändert. Die vorgeschlagene Unterfüllung 14 trägt im Gegenteil dazu bei, dass die von den Leistungshalbleitern 2, 4, 11 und 12 erzeugte Wärme insbesondere auf die Metallfolien 7, 9 des Folienverbunds 6 effizient abgeleitet und abgeführt wird.

### Bezugszeichenliste

- 1: Substrat
- 2: erster Leistungshalbleiter
- 3: erste Wärmeableitplatte
- 4: zweiter Leistungshalbleiter
- 5: zweite Wärmeableitplatte
- 6: Verbindungseinrichtung
- 7: erste Metallfolie
- 8: isolierende Folie
- 9: zweite Metallfolie
- 10: Kontakt
- 11: dritter Leistungshalbleiter
- 12: vierter Leistungshalbleiter
- 13: Kontaktfläche
- 14: Unterfüllung
- V1 - V6: Volumina

## Patentansprüche

1. Halbleiteranordnung, insbesondere Leistungshalbleiteranordnung, bei der ein eine mit Kontakten (10) versehene Oberseite aufweisender Halbleiter (2, 4, 11, 12) mit einer aus einem Folienverbund (7, 8, 9) gebildeten elektrischen Verbindungseinrichtung (6) verbunden ist, wobei zwischen der Verbindungseinrichtung (6) und der Oberseite des Halbleiters (2, 4, 11, 12) eine Unterfüllung (14) vorgesehen ist,
**dadurch gekennzeichnet, dass**
die Unterfüllung (14) eine aus einem präkeramischen Polymer gebildete Matrix aufweist und wobei das präkeramische Polymer in gelartiger oder duroplastischer Form vorliegt.

2. Halbleiteranordnung nach Anspruch 1, wobei das präkeramische Polymer mit einem Füllgrad von bis zu 80 Vol.%, vorzugsweise bis zu 50 Vol.%, mit einem Füllstoff gefüllt ist.

3. Halbleiteranordnung nach Anspruch 1 oder 2, wobei der Füllstoff ein aus einem keramischen Material gebildetes Pulver mit einer mittleren Korngröße im Bereich von 0,5 bis 500 µm ist.

4. Halbleiteranordnung nach einem der vorhergehenden Ansprüche, wobei die Wärmeleitfähigkeit λ des keramischen Materials bei Raumtemperatur größer als 10 W/mK, vorzugsweise größer als 20 W/mK, ist.

5. Halbleiteranordnung nach einem der Ansprüche 3 oder 4, wobei das keramische Material aus der folgenden Gruppe ausgewählt ist: BN, SiC, Si₃N₄, AlN, Steatit, Codierit.

6. Halbleiteranordnung nach einem der vorhergehenden Ansprüche, wobei das präkeramische Polymer aus der folgenden Gruppe ausgewählt ist: Polysiloxan, Polysilazan, Polycarbosilan.

7. Halbleiteranordnung nach einem der vorhergehenden Ansprüche, wobei eine der Oberseite abgewandte Unterseite des Halbleiters (2, 4, 11, 12) mit auf einem Substrat (1) verbunden ist.

## Claims

1. A semiconductor arrangement, particularly a power semiconductor arrangement, in which a semiconductor (2, 4, 11, 12) having an upper side provided with contacts (10) is connected to an electrical connecting device (6) formed from a film composite (7, 8, 9), wherein an underfilling (14) is provided between the connecting device (6) and the upper side of the semiconductor (2, 4, 11, 12),
**characterised in that**
the underfilling (14) has a matrix formed from a preceramic polymer and wherein the preceramic polymer is present in gel-like or duroplastic form.

2. The semiconductor arrangement according to Claim 1, wherein the preceramic polymer is filled with a filler with a filling level of up to 80% by volume, preferably up to 50% by volume.

3. The semiconductor arrangement according to Claim 1 or 2, wherein the filler is a powder formed from a ceramic material with an average particle size in the range from 0.5 to 500 µm.

4. The semiconductor arrangement according to one of the preceding claims, wherein the thermal conductivity λ of the ceramic material is larger than 10 W/mK, preferably larger than 20 W/mK at room temperature.

5. The semiconductor arrangement according to one of Claims 3 or 4, wherein the ceramic material is selected from the following group: BN, SiC, Si₃N₄, AlN, steatite, cordierite.

6. The semiconductor arrangement according to one of the preceding claims, wherein the preceramic polymer is selected from the following group: polysiloxane, polysilazane, polycarbosilane.

7. The semiconductor arrangement according to one of the preceding claims, wherein an underside of the semiconductor (2, 4, 11, 12) facing away from the upper side is connected to a substrate (1).

## Revendications

1. Agencement à semi-conducteur, en particulier agencement à semi-conducteur de puissance, sur lequel un semi-conducteur (2, 4, 11, 12) présentant un côté supérieur doté de contacts (10) est relié à un dispositif de liaison (6) électrique formé d'un assemblage de film (7, 8, 9), un remplissage inférieur (14) étant prévu entre le dispositif de liaison (6) et le côté supérieur du semi-conducteur (2, 4, 11, 12),
**caractérisé en ce que** :
le remplissage inférieur (14) présente une matrice formée d'un polymère précéramique, et le polymère précéramique étant présent sous forme de gel ou sous forme thermodurcissable.

2. Agencement à semi-conducteur selon la revendication 1, le polymère précéramique étant rempli avec un degré de remplissage allant jusqu'à 80 % en volume, de préférence jusqu'à 50 % en volume, avec une matière de charge.

3. Agencement à semi-conducteur selon la revendication 1 ou 2, la matière de charge étant une poudre formée à base d'un matériau céramique avec une grosseur de grain moyenne de l'ordre de 0,5 à 500 µm.

4. Agencement à semi-conducteur selon l'une des revendications précédentes, la conductibilité thermique λ du matériau céramique à la température ambiante étant supérieure à 10 W/mK, de préférence supérieure à 20 W/mK.

5. Agencement à semi-conducteur selon l'une des revendications 3 et 4, le matériau céramique étant choisi dans le groupe suivant : BN, SiC, Si₃N₄, AlN, stéatite, cordiérite.

6. Agencement à semi-conducteur selon l'une des revendications précédentes, le polymère précéramique étant choisi dans le groupe suivant : polysiloxane, polysilazane, polycarbosilane.

7. Agencement à semi-conducteur selon l'une des revendications précédentes, un côté inférieur, opposé au côté supérieur, du semi-conducteur (2, 4, 11, 12) étant relié à un substrat (1).
